# EUROPEAN PATENT APPLICATION

(11) **EP 0 923 093 A2**
(43) Date of publication of application: **16.06.1999**
(21) Application number: 98309662.9
(22) Date of filing: 25.11.1998
(51) Int. Cl.: H01G 4/06, H01L 29/92

(54) **Vertical array capacitor**

(30) Priority: 26.11.1997 US 66958 P
(71) Applicant: TEXAS INSTRUMENTS INCORPORATED, Dallas, TX 75265 (US)
(72) Inventor: Brennan, Ken D., Flower Mound, TX 75231 (US); Prinslow, Douglas A., McKinney, TX 75070 (US); Singh, Abha, Garland, TX 75044 (US)
(74) Representative: Holt, Michael

(57) **Abstract**

The invention comprises a capacitor (27) including a supporting dielectric layer (20) disposed outwardly from a semiconductor substrate (14), the supporting dielectric layer (20) having a plurality of cavities (26) extending inwardly from an outer surface of the supporting dielectric layer (20) toward the substrate (14), the plurality of cavities (26) forming a topography on an outer surface of the supporting dielectric. A first conductive layer (28) is disposed outwardly from the supporting dielectric layer (20), approximately conforming to the topography of the supporting dielectric layer (20). A capacitor dielectric layer (30) is disposed outwardly from the first conductive layer (28), approximately conforming to the topography of the dielectric layer (20). A second conductive layer (32) is disposed outwardly from the capacitor dielectric layer (30).

## Description

### TECHNICAL FIELD OF THE INVENTION

This invention relates generally to the field of electronic devices and more particularly to a vertical array capacitor.

### BACKGROUND OF THE INVENTION

Integrated circuit elements such as digital-to-analog converters typically implement capacitors to temporarily store data for processing. One method of integrating a capacitor in an integrated circuit is to form a parallel plate capacitor using conductive plates disposed outwardly from the semiconductor substrate and parallel to the substrate surface. A problem with this approach is that to increase the capacitance of the device, one typically increases the area of the flat conductive plates. Increasing the area of the flat conductive plates results in a corresponding increase in parasitic capacitance between the conductive plate and the substrate. In addition, increasing the area of the conductive plates is undesirable where the substrate surface area is limited. Another problem with this approach is that the bottom conductive plate typically comprises doped polysilicon, which exhibits high sheet resistance resulting in the capacitor having high series resistance.

### SUMMARY OF THE INVENTION

In accordance with the teachings disclosed herein, a capacitor is provided that eliminates or substantially reduces problems associated with prior approaches.

According to one embodiment, a capacitor is provided that comprises a supporting dielectric layer disposed outwardly from a semiconductor substrate, the supporting dielectric layer having a plurality of cavities extending inwardly from an outer surface of the supporting dielectric layer toward the substrate, the plurality of cavities forming a topography on an outer surface of the supporting dielectric layer. The capacitor may further comprise a first conductive layer disposed outwardly from the supporting dielectric layer, and approximately conforming to the topography of the supporting dielectric layer. A capacitor dielectric layer is disposed outwardly from the first conductive layer. A second conductive layer is disposed outwardly from the capacitor dielectric layer.

The capacitor according to the disclosed teachings has several important technical advantages. A majority of the capacitor surface area may be oriented normal to the surface of the substrate, thus minimizing coupling between the capacitor and the substrate. Therefore, parasitic capacitance between a capacitor and the substrate is minimized. Additionally, the configurations of the capacitor and dielectric region provide a large capacitance per unit of substrate area. Larger capacitance per unit of substrate area saves valuable substrate surface area. This allows space for additional circuit elements, or alternatively, facilitates building more devices per wafer, resulting in a lower cost per device. Providing large capacitance per unit area also gives capacitors a small footprint compared to a parallel plate capacitor, facilitating aggressive device scaling.

### BRIEF DESCRIPTION OF THE DRAWINGS

A more complete understanding of the disclosed teachings may be acquired by referring to the accompanying figures in which like reference numbers indicate like features and wherein;
FIGURE 1 is a cross-sectional view of a portion of an integrated circuit having a capacitor; and
FIGURES 2a-2e are cross-sectional views of a portion of a partially completed integrated circuit having capacitors.

### DETAILED DESCRIPTION OF THE INVENTION

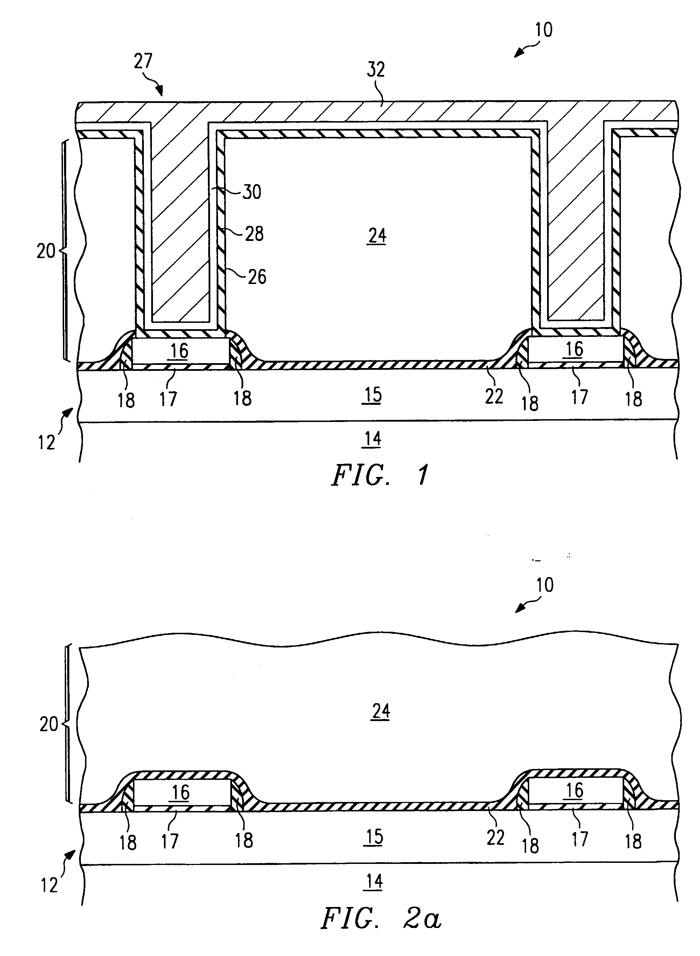

FIGURE 1 is a cross-sectional view of a portion of an integrated circuit having a capacitor. Integrated circuit 10 may include a first intermediate structure 12. First intermediate structure 12 may comprise a semiconductor substrate 14, a field oxide layer 15 disposed outwardly from substrate 14, gate dielectrics 17 disposed outwardly from field oxide layer 15, etch stops 16 disposed outwardly from gate dielectrics 17, and isolation dielectrics 18 disposed between etch stops 16. In another embodiment (not explicitly shown), field oxide layer 15 may be replaced with a shallow trench isolation (STI) structure.

A dielectric layer 20 may be formed outwardly from first intermediate structure 12. Dielectric layer 20 may comprise a relatively thin undoped dielectric layer 22 disposed outwardly from first intermediate structure 12. Dielectric layer 20 may further comprise a doped dielectric layer 24 disposed outwardly from undoped dielectric layer 22. Dielectric layer 20 may comprise a supporting dielectric layer having a plurality of cavities 26 extending inwardly from its outer surface. Throughout this document, the term "supporting dielectric layer" refers to a layer of dielectric supporting the plurality of cavities 26. Supporting dielectric layer 20 may comprise any number of cavities 26, depending on the device characteristics desired. In a particular embodiment, supporting dielectric layer 20 may comprise an array of cavities 26. Supporting dielectric layer 20 could be any type of dielectric material or materials with one or multiple layers without departing from the scope of the teachings disclosed herein.

Where cavities 26 are formed within supporting dielectric layer 20, etch stops 16 may aid in defining the extent of cavities 26. In the illustrated embodiment, etch stops 16 may comprise polysilicon gate structures formed during the fabrication of transistors (not explicitly shown) integral to integrated circuit 10. In another embodiment, primary etch stops (not explicitly shown) may be formed outwardly from the aforementioned polysilicon gate structures. These primary etch stops may comprise, for example, silicon carbide or silicon nitride. In still another embodiment, the aforementioned polysilicon gate structures may be etched away and replaced with subsequently-formed etch stops comprising, for example, silicon carbide or silicon nitride.

A first conductive layer 28 may be formed outwardly from supporting dielectric layer 20 to approximately conform to the topography of dielectric layer 20. First conductive layer 28 may serve as a first contact for a built-in capacitor 27. First conductive layer 28 may comprise any conformal conductive material. For example, first conductive layer 28 may comprise of titanium nitride formed through chemical vapor deposition. First conductive layer 28 may alternatively be formed from any number of conductive materials, such as, titanium, titanium aluminum nitride, titanium silicon nitride, tantalum, tantalum nitride, tantalum silicon nitride, tungsten nitride or tungsten silicon nitride. Particular materials, dimensions and methods of forming various layers mentioned throughout this document are specified for exemplary purposes only. Various materials of different dimensions may be formed in any suitable manner without departing from the scope of the teachings disclosed herein.

A capacitor dielectric layer 30 may be disposed outwardly from first conductive layer 28. Capacitor dielectric layer 30 may be formed to approximately conform to the topography of supporting dielectric layer 20 and first conductive layer 28. Capacitor dielectric layer 30 may comprise, for example, a layer of silicon nitride. Alternatively, capacitor dielectric layer 30 may comprise another dielectric material, such as silicon dioxide, silicon carbide, or any suitable combination of dielectric materials. A second conductive layer 32 may be formed outwardly from capacitor dielectric layer 30. Second conductive layer 32 may serve as a second contact for built-in capacitor 27. Second conductive layer 32 may be formed from any appropriate conductive material. Second conductive layer 32 may, but need not be, formed from the same material used in first conductive layer 26. Second conductive layer 32 may be formed, for example, by disposing a conductive material outwardly from capacitor dielectric layer 30 to completely fill cavities 26. Alternatively, second conductive layer 32 may be formed by disposing a thin conforming layer of conductive material outwardly from capacitor dielectric layer 30 (not explicitly shown). First conductive layer 28, capacitor dielectric layer 30 and second conductive layer 32 form built-in capacitor 27.

In an alternative embodiment (not explicitly shown), built-in capacitor 27 may be formed within cavities 26 formed in an inter-level supporting dielectric layer (not explicitly shown) disposed outwardly from dielectric layer 20. In this embodiment, a metal-one layer (not explicitly shown) is disposed outwardly from dielectric layer 20. The inter-level supporting dielectric layer is then disposed outwardly from a metal-one layer. The metal-one layer may comprise any first metal layer disposed outwardly from etch stops 16 and separated from etch stops 16 by dielectric layer 20. The metal-one layer may function as an etch stop for cavities 26 formed in the supporting inter-level dielectric layer. The structure and function of built-in capacitor 27 in this embodiment is consistent with the description of the embodiment illustrated in FIGURE 1, except that the cavities are formed in an inter-level supporting dielectric layer, rather than in dielectric layer 20. This embodiment may advantageously provide increased isolation of the capacitor from the substrate, further reducing parasitic capacitance of the device.

FIGURES 2a-2e are cross-sectional views of a portion of a partially completed integrated circuit having capacitors constructed according to the teachings disclosed herein. The description of FIGURES 2a-2e refers to an embodiment in which dielectric layer 20 serves as the supporting dielectric layer. However, as described above, an inter-level dielectric layer (not explicitly shown) disposed outwardly from dielectric layer 20 may serve as the supporting dielectric layer without departing from the scope of the invention.

FIGURE 2a shows integrated circuit 10 after dielectric layer 20 has been formed outwardly from first intermediate structure 12. First intermediate structure 12 may be fabricated by any appropriate method and may include etch stops 16 disposed outwardly from semiconductor substrate 14 and separated by gate oxide 17, as well as isolation dielectric regions 18 disposed between etch stops 16. As described above, etch stops 16 may comprise polysilicon gate structures, or silicon carbide or silicon nitride structures formed outwardly from, or in place of the polysilicon gate structures shown in FIGURE 2a.

Dielectric layer 20 may be formed by initially forming undoped dielectric layer 22 outwardly from first intermediate structure 12. Doped dielectric layer 24 may then be disposed outwardly from undoped dielectric layer 22 to complete the structure of dielectric layer 20. Where dielectric layer 20 does not serve as the supporting dielectric layer for cavities 26, a metal-one layer may next be formed outwardly from dielectric layer 20 using any appropriate fabrication process, such as a pattern and etch. An inter-level supporting dielectric layer may then be formed outwardly from the metal-one layer. In that case, cavities 26 are subsequently formed in the inter-level supporting dielectric layer.

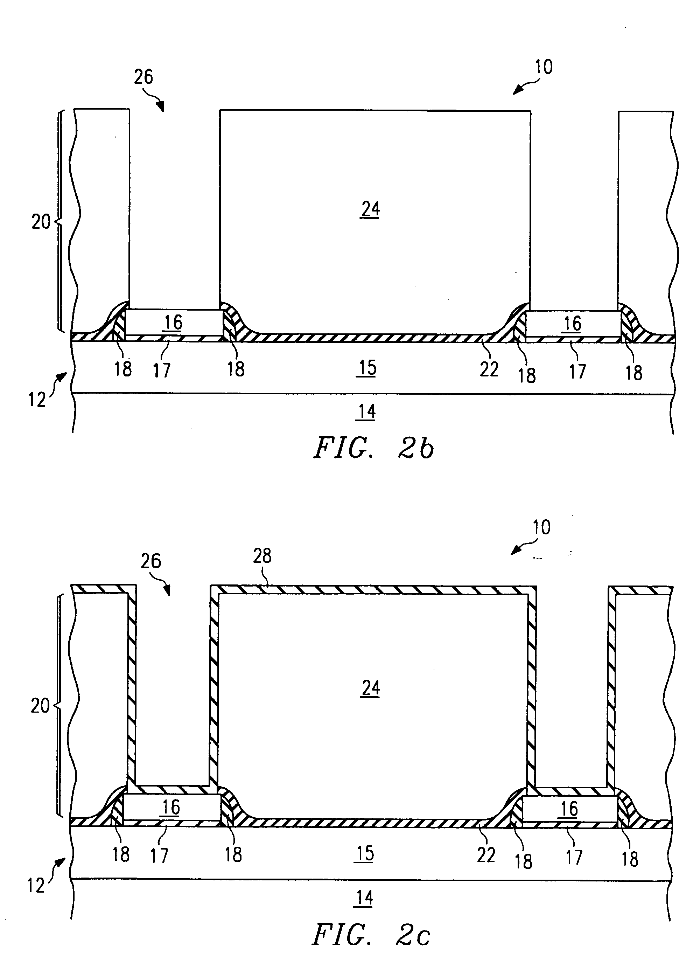

The remainder of this discussion assumes that dielectric layer 20, rather than an inter-level dielectric layer, serves as the supporting dielectric layer for cavities 26 and built-in capacitor 27. FIGURE 2b shows integrated circuit 10 after cavities 26 have been formed in dielectric layer 20. Initially, supporting dielectric layer 20 may be planarized to remove any topography resulting from disposing the dielectric over etch stops 16. Next, one or more cavities 26 may be formed to extend inwardly from an outer surface of supporting dielectric layer 20 toward substrate 14. Cavities 26 may be formed through any appropriate method, such as, by patterning and etching supporting dielectric layer 20. Cavities 26 may comprise any size or configuration, depending on the desired device characteristics. Cavities 26 may be oriented vertically with respect to substrate 14. Orienting cavities 26 vertically with respect to the substrate provides an advantage of minimizing parasitic capacitance between conductive layer 28 and substrate 14.

FIGURE 2c shows integrated circuit 10 after formation of first conductive layer 28. First conductive layer 28 may be formed, for example, through chemical vapor deposition of a conformal conductive material, such as, titanium nitride. Any method of forming a conformal conductive layer of material may be used without departing from the scope of the disclosed teachings.

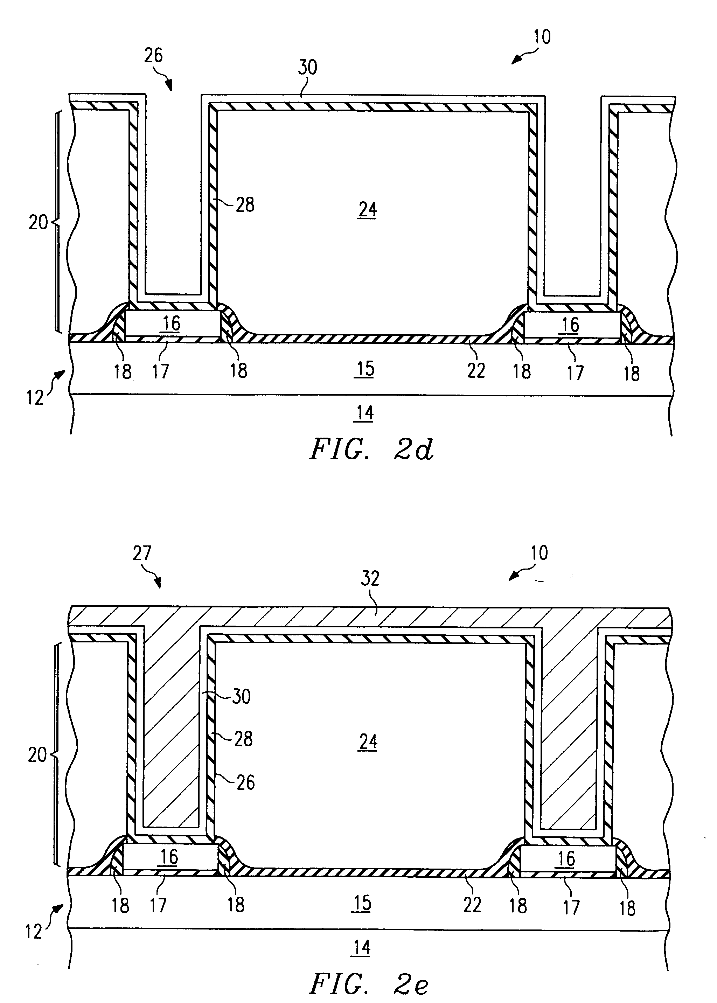

FIGURE 2d illustrates integrated circuit 10 after capacitor dielectric layer 30 has been formed. Capacitor dielectric layer 30 may be formed, for example, by growing or depositing a conformal layer or layers of dielectric outwardly from first conductive layer 28. Any method of forming a layer of conformal dielectric material outwardly from first conductive layer 28 may be used without departing from the scope of this disclosed teachings.

FIGURE 2e shows integrated circuit 10 after second conductive layer 32 has been formed. Second conductive layer 32 is formed outwardly from capacitor dielectric layer 30. Second conductive layer 32 may be formed, for example, by disposing a conductive material outwardly from capacitor dielectric layer 30 to completely fill cavity 26. Alternatively, second conductive layer 32 may be formed by disposing a layer of conformal conductive material outwardly from capacitor dielectric layer 30 (not explicitly shown). Second conductive layer 32 may be formed by any appropriate process such as chemical vapor deposition.

Subsequent to formation of second conductive layer 32, a pattern and etch may be performed to facilitate external connection to built-in capacitor 27. For example, a region of second conductive layer 32 may be etched away to expose capacitor dielectric layer 30 or first conductive layer 28. Any process effective to remove a portion of second conductive layer 32 may be utilized. For example, a region of the perimeter of second conductive layer 32 may be etched to expose the perimeter of the first conductive layer. Vias (not explicitly shown) may then be coupled to the perimeter of first conductive layer 28 and to an exposed region of second conductive layer 32. In another embodiment, a hole may be etched through, for example, the center of second conductive layer 32 to expose an underlying region of first conductive layer 28. Again, vias may be fabricated to form external connections to exposed regions of first conductive layer 28 and second conductive layer 32.

First conductive layer 28, capacitor dielectric layer 30 and second conductive layer 32 form built-in capacitor 27. Built-in capacitor 27 provides an advantage of minimizing parasitic capacitance between first conductive layer 28 and substrate 14 of integrated circuit 10. Fabricating built-in capacitor 27 within an inter-level supporting dielectric layer provides further isolation of first conductive layer 28 from substrate 14. Additionally, built-in capacitor 27 exhibits a high capacitance per unit area of substrate, allowing designers to minimize the footprint of the device while maintaining appropriate levels of capacitance.

Although the present invention has been described in detail, it should be understood that various changes and substitutions can be made hereto without departing from the spirit and scope of the invention.

## Claims

1. A capacitor comprising:
a supporting dielectric layer disposed outwardly from a semiconductor substrate, the supporting dielectric layer having a plurality of cavities extending inwardly from an outer surface of the dielectric layer toward the substrate, the plurality of cavities forming a topography on an outer surface of the supporting dielectric layer;
a first conductive layer disposed outwardly from the supporting dielectric layer and approximately conforming to the topography of the supporting dielectric layer;
a capacitor dielectric layer disposed outwardly from the first conductive layer; and
a second conductive layer disposed outwardly from the capacitor dielectric layer.
2. The capacitor of Claim 1, wherein the supporting dielectric layer comprises:
an undoped layer of dielectric formed outwardly from the semiconductor substrate; and
a doped layer of dielectric formed outwardly from the undoped layer of dielectric.
3. The capacitor of Claim 2, further comprising:
a metal-one layer disposed outwardly from the doped layer of dielectric; and
wherein the supporting dielectric layer comprises an inter-level dielectric layer disposed outwardly from the metal-one layer.
4. The capacitor of any of Claims 1 to 3, wherein the first conductive layer comprises a material selected from the group consisting of titanium, titanium nitride, titanium aluminum nitride, titanium silicon nitride, tantalum, tantalum nitride, tantalum silicon nitride, tungsten nitride and tungsten silicon nitride.
5. The capacitor of any of Claims 1 to 4, wherein the capacitor dielectric layer comprises a material selected from the group consisting of silicon oxide, silicon nitride, and silicon carbide.
6. The capacitor of any of Claims 1 to 5, wherein the second conductive layer substantially fills a remainder of at least one cavity in the dielectric layer, the remainder comprising the portion of the at least one cavity not filled by the first conductive layer and the capacitor dielectric layer.
7. The capacitor of any of Claims 1 to 6, wherein the second conductive layer comprises a conformal layer disposed outwardly from the capacitor dielectric layer and approximately conforming to the topography of the dielectric layer.
8. The capacitor of any of Claims 1 to 7, wherein the second conductive layer comprises a material selected from the group consisting of titanium, titanium nitride, titanium aluminum nitride, titanium silicon nitride, tantalum, tantalum nitride, tantalum silicon nitride, tungsten nitride and tungsten silicon nitride.
9. An integrated circuit comprising at least one capacitor, the or each capacitor comprising:
a supporting dielectric layer disposed outwardly from a semiconductor substrate having a plurality of cavities extending inwardly from an outer surface of the dielectric layer toward the substrate, the plurality of cavities forming a topography on an outer surface of the supporting dielectric layer;
a first conductive layer disposed outwardly from the supporting dielectric layer and approximately conforming to the topography of the supporting dielectric layer;
a capacitor dielectric layer disposed outwardly from the first conductive layer; and
a second conductive layer disposed outwardly from the capacitor dielectric layer.
9. A method of forming a capacitor comprising:
forming a supporting dielectric layer outwardly from a semiconductor substrate;
forming a plurality of cavities extending inwardly from an outer surface of the supporting dielectric layer toward the substrate, the plurality of cavities forming a topography on an outer surface of the supporting dielectric layer;
forming a first conductive layer disposed outwardly from the supporting dielectric layer and approximately conforming to the topography of the supporting dielectric layer;
forming a capacitor dielectric layer disposed outwardly from the first conductive layer; and
forming a second conductive layer disposed outwardly from the capacitor dielectric layer.
10. The method of Claim 9, further comprising:
forming an undoped layer of dielectric outwardly from the semiconductor substrate;
forming a doped layer of dielectric outwardly from the undoped layer of dielectric; and
forming a metal-one layer outwardly from the doped layer of dielectric; and
wherein the step forming the supporting dielectric layer comprises forming an inter-level dielectric layer outwardly from the metal-one layer.
